(19) Europäisches Patentamt / European Patent Office / Office européen des brevets

(11) **EP 4 742 490 A1**

(12) **EUROPEAN PATENT APPLICATION**
published in accordance with Art. 153(4) EPC

(43) Date of publication:
**13.05.2026 Bulletin 2026/20**

(21) Application number: **25816144.7**

(22) Date of filing: **21.03.2025**

(51) International Patent Classification (IPC):
*H02J 7/00* (2026.01)   *G01R 31/382* (2019.01)
*G01R 31/389* (2019.01)   *H01M 10/44* (2006.01)

(52) Cooperative Patent Classification (CPC):
**G01R 31/382; G01R 31/389; H01M 10/44;
H02J 7/00**

(86) International application number:
**PCT/KR2025/003657**

(87) International publication number:
**WO 2025/249729 (04.12.2025 Gazette 2025/49)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.05.2024 KR 20240069604**

(71) Applicant: **LG Energy Solution, Ltd.
Seoul 07335 (KR)**

(72) Inventors:
• **WHANG, Tae-Kyung**
  **Daejeon 34122 (KR)**
• **PARK, Tae-Soon**
  **Daejeon 34122 (KR)**
• **LEE, Ji-Eun**
  **Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **CHARGING PROTOCOL GENERATION DEVICE AND METHOD**

(57)   A charging protocol generating apparatus according to an embodiment of the present disclosure includes a protocol obtaining unit configured to obtain a charging protocol representing a corresponding relationship between a charging c-rate and a charging limit SOC of a battery; a profile obtaining unit configured to obtain a resistance profile based on a reference profile representing a corresponding relationship between SOC and resistance of the battery in a charging process according to the charging c-rate and a criterion profile corresponding to a preset criterion c-rate; and a control unit configured to correct the charging protocol by changing the charging c-rate of the charging protocol based on the resistance profile.

FIG. 1

CHARGING PROTOCOL GENERATING APPARATUS — 100
PROTOCOL OBTAINING UNIT — 110
PROFILE OBTAINING UNIT — 120
CONTROL UNIT — 130
STORAGE UNIT — 140

## Description

TECHNICAL FIELD

The present disclosure relates to a charging protocol generating apparatus and method.

This application is based on and claims priority from Korean Patent Application No. 10-2024-0069604, filed on May 28, 2024, with the Korean Intellectual Property Office, the disclosure of which is incorporated herein in its entirety by reference.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

As electric vehicles, electric motorcycles, and electric bicycles, etc., are commercialized, the demand for high-capacity and high-performance batteries is increasing. However, as the capacity of the battery increases, the time required to charge the battery also increases, which is a disadvantage. To solve this problem, a technology for rapidly charging batteries is being developed, but there is a concern that rapid charging may accelerate battery deterioration. Therefore, in order to prevent battery deterioration due to rapid charging, a rapid charging protocol that may efficiently charge the battery is required.

In particular, it is necessary to prevent the phenomenon of lithium metal being deposited on the surface of the negative electrode (lithium plating). If lithium is deposited on the surface of the negative electrode, it causes side reactions with the electrolyte and changes in the kinetic balance of the battery, which may cause battery deterioration. In addition, since an internal short circuit may occur in the battery as lithium metal is deposited on the surface of the negative electrode, there is a risk of ignition and explosion due to the internal short circuit.

In addition, it is necessary to prevent the phenomenon of the positive electrode structure collapsing due to overvoltage formation during rapid charging. For example, in the case of a manganese-rich battery, manganese element eluted due to the structural collapse of the positive electrode during rapid charging may be detected on the surface of the negative electrode. This has a negative effect on the capacity retention rate of the battery.

Therefore, a rapid charging protocol is required that may prevent a decrease in the capacity retention rate of the battery by avoiding the phenomenon of lithium metal precipitation on the negative electrode surface and collapse of the positive electrode structure.

DISCLOSURE

Technical Problem

The present disclosure is designed to solve the problems of the related art, and therefore the present disclosure is directed to providing a charging protocol generating apparatus and method that generates a charging protocol capable of preventing a decrease in the capacity retention rate of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A charging protocol generating apparatus according to one aspect of the present disclosure may comprise a protocol obtaining unit configured to obtain a charging protocol representing a corresponding relationship between a charging c-rate and a charging limit SOC of a battery; a profile obtaining unit configured to obtain a resistance profile based on a reference profile representing a corresponding relationship between SOC and resistance of the battery in a charging process according to the charging c-rate and a criterion profile corresponding to a preset criterion c-rate; and a control unit configured to correct the charging protocol by changing the charging c-rate of the charging protocol based on the resistance profile.

The control unit may be configured to determine a target SOC section in the resistance profile and change a target c-rate corresponding to the target SOC section in the charging protocol.

The control unit may be configured to reduce the target c-rate.

The control unit may be configured to detect at least one peak in the resistance profile and determine the target SOC section based on the detected peak.

The control unit may be configured to determine a target peak having a smallest corresponding SOC among the at least one peak and determine a SOC section including a target SOC of the target peak as the target SOC section.

The control unit may be configured to determine a SOC section within a predetermined range from the target SOC as the target SOC section.

When there are a plurality of charging c-rates, the control unit may be configured to determine the target SOC section based on one of a plurality of resistance profiles corresponding to the plurality of charging c-rates.

The control unit may be configured to determine the target SOC section in a resistance profile having a largest corresponding charging c-rate among the plurality of resistance profiles.

The charging process may be configured to alternately repeat a charging mode and a rest mode.

The reference profile may be configured to represent a corresponding relationship between a resistance calculated based on a voltage change amount during each rest mode and a SOC corresponding to each rest mode.

The charging protocol may be configured to set a corresponding charging limit SOC for each charging c-rate based on a change pattern of the resistance according to an increase in SOC of the reference profile.

The resistance profile may be configured to represent a difference between a resistance for each SOC of the reference profile and a resistance for each SOC of the criterion profile.

A server according to another aspect of the present disclosure may include the charging protocol generating apparatus according to one aspect of the present disclosure.

A battery management device according to still another aspect of the present disclosure may be configured to receive a corrected charging protocol from the charging protocol generating apparatus according to one aspect of the present disclosure, and to control charging of a charging target battery based on the corrected charging protocol.

A charging protocol generating method according to still another aspect of the present disclosure may comprise a protocol obtaining step of obtaining a charging protocol representing a corresponding relationship between a SOC of a battery and a charging c-rate; a profile obtaining step of obtaining a resistance profile based on a reference profile representing a corresponding relationship between the SOC and a resistance of the battery in a charging process according to the charging c-rate and a criterion profile corresponding to a preset criterion c-rate; and a protocol correcting step of correcting the charging protocol by changing the charging c-rate of the charging protocol based on the resistance profile.

## Advantageous Effects

According to one aspect of the present disclosure, since the charging protocol may be corrected by considering the resistance of the battery, a decrease in the capacity retention rate of the battery may be prevented.

In addition, according to one aspect of the present disclosure, since the charging protocol may be corrected by considering a plurality of resistance profiles, a decrease in the capacity retention rate of the battery may be prevented, and also the charging time of the battery may be shortened.

The effects of the present disclosure are not limited to the effects mentioned above, and other effects not mentioned will be clearly understood by those skilled in the art from the description of the claims.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a schematic drawing of a charging protocol generating apparatus according to an embodiment of the present disclosure.

FIG. 2 is a schematic drawing of a charging protocol according to an embodiment of the present disclosure.

FIG. 3 is a schematic drawing illustrating a resistance profile according to an embodiment of the present disclosure.

FIG. 4 is a schematic time-series drawing illustrating a battery voltage measured during a charging process according to an embodiment of the present disclosure.

FIG. 5 is an enlarged drawing illustrating a partial region of FIG. 4.

FIG. 6 is a drawing illustrating an example of a state in which lithium metal precipitates are formed on a negative electrode of a battery.

FIG. 7 is a drawing illustrating a plurality of resistance profiles according to an embodiment of the present disclosure.

FIG. 8 to FIG. 10 are drawings illustrating reference profiles obtained during a charging process under different charging conditions.

FIG. 11 is a drawing illustrating an example of a complex impedance curve of a battery.

FIG. 12 is a drawing illustrating an exemplary configuration of a battery pack including a battery management device according to another embodiment of the present disclosure.

FIG. 13 is a drawing illustrating an exemplary configuration of a charging device including a battery management device according to still another embodiment of the present disclosure.

FIG. 14 is a diagram schematically showing a charging protocol generating method according to still another embodiment of the present disclosure.

## BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

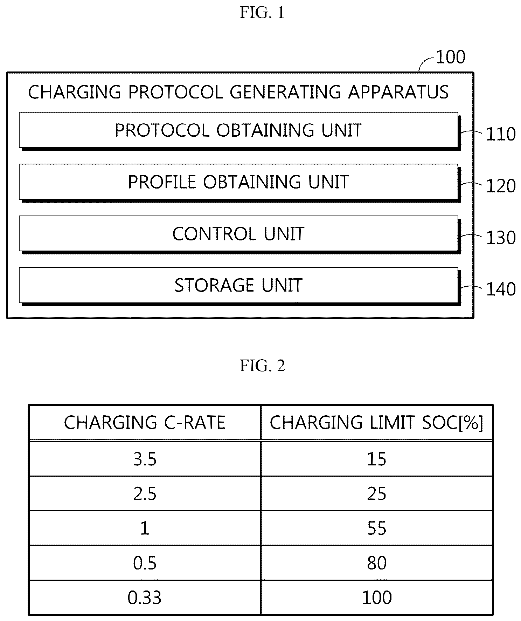

FIG. 1 is a diagram schematically illustrating a charging protocol generating apparatus 100 according to an embodiment of the present disclosure.

Referring to FIG. 1, the charging protocol generating apparatus 100 may include a protocol obtaining unit 110, a profile obtaining unit 120, and a control unit 130.

The protocol obtaining unit 110 may be configured to obtain a charging protocol that represents a corresponding relationship between a charging c-rate and a charging limit SOC (State of Charge) of a battery.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

Specifically, the charging protocol may be configured to indicate a charging limit SOC for each charging c-rate. The charging limit SOC refers to a maximum SOC at which charging can be performed without lithium plating when the battery is charged at a corresponding charging c-rate. In general, when the battery is charged at the same charging c-rate, the lithium plating phenomenon tends to be more likely to occur in a high SOC region than in a relatively low SOC region. That is, the high SOC region tends to be vulnerable to lithium plating when the battery is charged. In addition, the charging limit SOC tends to decrease as the charging c-rate increases. Therefore, the charging limit SOC corresponding to the charging c-rate may be determined with respect to the timing of lithium plating occurrence.

FIG. 2 is a schematic drawing of a charging protocol according to an embodiment of the present disclosure. Referring to FIG. 2, it may be confirmed that as the charging c-rate increases, the corresponding charging limit SOC decreases. Specifically, when the charging c-rate is 3.5 C, the charging limit SOC is 15%. When the charging c-rate is 2.5 C, the charging limit SOC is 25%. When the charging c-rate is 1 C, the charging limit SOC is 55%. When the charging c-rate is 0.5 C, the charging limit SOC is 80%. When the charging c-rate is 0.33 C, the charging limit SOC is 100%.

For example, the protocol obtaining unit 110 may directly receive a charging protocol from the outside. That is, the protocol obtaining unit 110 may receive a charging protocol by being connected to the outside via wired and/or wireless means. For example, the protocol obtaining unit 110 may receive a charging protocol from the outside using CAN (Controller Area Network) communication or CAN-FD (CAN with Flexible Data rate) communication. As another example, the protocol obtaining unit 110 may receive a charging protocol from the outside using Zigbee, Bluetooth, WIFI, or a mobile communication network. Of course, as long as it supports communication between the protocol obtaining unit 110 and the outside, the type of communication protocol is not particularly limited.

As another example, the protocol obtaining unit 110 may receive a reference profile indicating a corresponding relationship between the SOC and resistance of the battery from the outside. Then, the protocol obtaining unit 110 may generate a charging protocol based on the received reference profile. Specifically, the protocol obtaining unit 110 may generate a charging protocol based on a change pattern of resistance according to an increase in SOC of the reference profile.

As still another example, the protocol obtaining unit 110 may receive battery information about the voltage and current of the battery from the outside. Then, the protocol obtaining unit 110 may estimate the resistance and SOC of the battery based on the received battery information to generate a reference profile. The SOC is a ratio of the remaining capacity to the fully charged capacity of the battery and may be expressed as a value within the range of 0 to 1 or 0 to 100%. Known methods such as ampere counting, OCV (Open Circuit Voltage)-SOC curve, and/or Kalman filter may be utilized for SOC estimation. The protocol obtaining unit 110 may generate a charging protocol based on the generated reference profile.

For convenience of explanation, a specific example in which a charging protocol is generated based on a reference profile is described below.

Meanwhile, the rapid charging protocol may be configured based on a charging protocol representing a corresponding relationship between a charging c-rate and a charging limit SOC. Preferably, the rapid charging protocol may be configured to divide a SOC section into at least one SOC section based on the charging limit SOC, so that an allowable maximum charging c-rate corresponds to each SOC section. The allowable maximum charging c-rate for each SOC section may mean a charging c-rate corresponding to an upper limit SOC of each SOC section in the charging protocol. By using this rapid charging protocol, the battery may be charged at a high rate within a limit in which a lithium plating phenomenon does not occur. That is, by using the rapid charging protocol based on a charging protocol, the charging time may be shortened while preventing accelerated degradation of the battery.

For example, the rapid charging protocol according to the embodiment of FIG. 2 may be configured as follows. Based on a plurality of charging limit SOCs (15%, 25%, 55%, 80%, 100%), the 0 to 100% SOC section may be divided into a total of five SOC sections. For example, the SOC 0 to 100% section may be divided into a SOC 0 to 15% section, a SOC 15 to 25% section, a SOC 25 to 55% section, a SOC 55 to 80% section, and a SOC 80 to 100% section. In addition, an allowable maximum charging c-rate may be configured to correspond to each SOC section.

Specifically, the allowable charging c-rate for the SOC 0 to 15% section is 3.5 C, 2.5 C, 1 C, 0.5 C, and 0.33 C. Therefore, the allowable maximum charging c-rate for the SOC 0 to 15% section is 3.5 C. The allowable charging c-rate for the SOC 15 to 25% section is 2.5 C, 1 C, 0.5 C, and 0.33 C. Therefore, the allowable maximum charging c-rate for the SOC 15 to 25% section is 2.5 C. The allowable charging c-rate for the SOC 25 to 55% section is 1 C, 0.5 C, and 0.33 C. Therefore, the allowable maximum charging c-rate for the SOC 25 to 55% section is 1 C. For SOC 55 to 80% section, the allowable charging c-rate is 0.5 C and 0.33 C. Therefore, the allowable maximum charging c-rate for SOC 55 to 80% section is 0.5 C. For SOC 80 to 100% section, the allowable charging c-rate is 0.33 C. Therefore, the allowable maximum charging c-rate for SOC 80 to 100% section is 0.33 C.

That is, the rapid charging protocol may be configured to correspond to a charging c-rate of 3.5 C for the SOC 0 to 15% section, a charging c-rate of 2.5 C for the SOC 15 to 25% section, a charging c-rate of 1 C for the SOC 25 to 55% section, a charging c-rate of 0.5 C for the SOC 55 to 80% section, and a charging c-rate of 0.33 C for the SOC 80 to 100% section.

The protocol obtaining unit 110 may be connected to communicate with the profile obtaining unit 120 and the control unit 130. For example, the protocol obtaining unit 110 may be connected to the profile obtaining unit 120 and the control unit 130 by wire and/or wirelessly. The protocol obtaining unit 110 may transmit the acquired charging protocol to the profile obtaining unit 120 and the control unit 130.

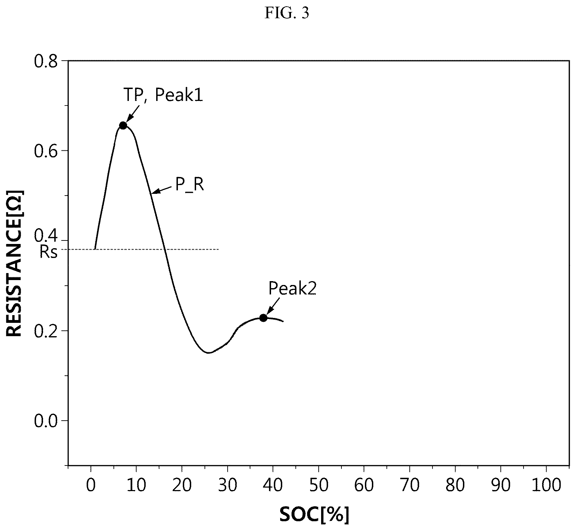

FIG. 3 is a schematic drawing illustrating a resistance profile according to an embodiment of the present disclosure.

In the embodiment of FIG. 3, the horizontal axis (X-axis) represents SOC (%), and the vertical axis (Y-axis) represents resistance (ohm).

The profile obtaining unit 120 may be configured to obtain a resistance profile based on a reference profile representing a corresponding relationship between the SOC and resistance of the battery obtained in a charging process according to a charging c-rate and a criterion profile corresponding to a preset criterion c-rate.

Specifically, the charging process may be performed within a preset voltage range. That is, the charging process may be performed until the voltage of the battery reaches a preset charging upper limit voltage from a preset charging lower limit voltage. The voltage range may be preset by considering the size of the charging c-rate and/or the battery temperature at the start time of the charging process.

The charging process may be configured so that the charging mode and rest mode are alternately repeated.

Here, the charging mode may mean a period of time for charging the battery at a predetermined charging c-rate. That is, in the charging mode, the charging current may be supplied to the battery. The rest mode may mean a period of time for stopping charging the battery. That is, in the rest mode, the supply of the charging current to the battery may be cut off.

If the first switching condition is satisfied, the charging mode may be switched to the rest mode. The first switching condition may be a time-based condition or a SOC-based condition. For example, if the duration time of the charging mode (i.e., the elapsed time from the start time of the charging mode) reaches the first criterion time, the first switching condition may be considered to be satisfied. As another example, if the SOC increase amount of the battery during the charging mode reaches the criterion increase amount, the first switching condition may be considered to be satisfied.

When the second switching condition is satisfied, the rest mode may be switched to the charging mode. The second switching condition may be a time-based condition. For example, when the duration time of the rest mode (i.e., the elapsed time from the start time of the rest mode) reaches the second criterion time, it may be considered that the second switching condition is satisfied. The second criterion time may be set in advance. Preferably, the second criterion time may be set in advance based on electrochemical characteristic data of the battery. For example, the second criterion time may be set in advance by considering the charge transfer resistance value of the battery. And the charge transfer resistance of the battery may be estimated based on EIS (Electrochemical Impedance Spectroscopy) data. For convenience of explanation, a specific example of determining the second criterion time based on EIS data will be described later.

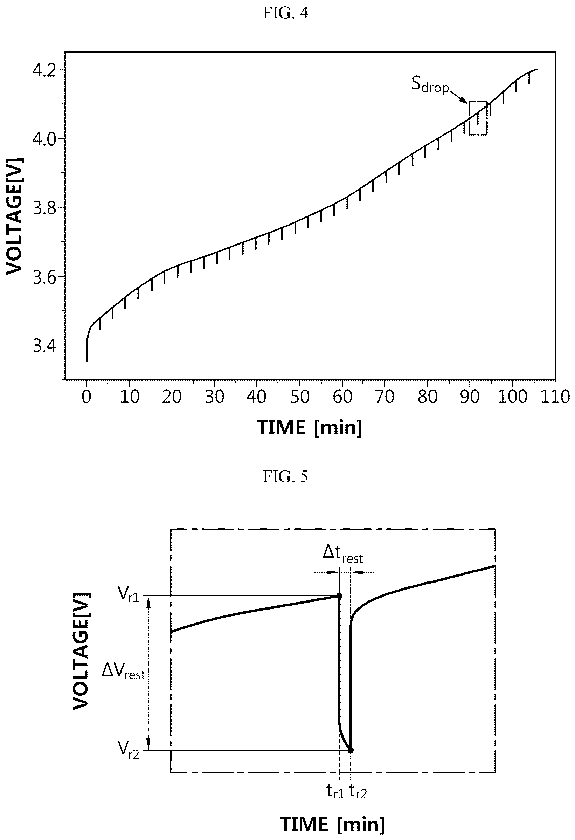

FIG. 4 is a schematic time-series drawing illustrating a battery voltage measured during a charging process according to an embodiment of the present disclosure.

In the embodiment of FIG. 4, the horizontal axis (X-axis) represents time (minutes), and the vertical axis (Y-axis) represents voltage (V) of the battery.

Referring to FIG. 4, it may be seen that the voltage of the battery tends to increase overall during the charging period, and the voltage increase section in the charging mode and the voltage decrease section in the rest mode are alternately repeated.

The reference profile may be configured to represent a corresponding relationship between the resistance calculated based on the voltage change amount during each rest mode and the SOC corresponding to each rest mode.

For example, resistance corresponding to each rest mode may be calculated using Ohm's law. Specifically, the value obtained by dividing the voltage change amount during the rest mode by the charging current value may be calculated as resistance.

FIG. 5 is an enlarged drawing illustrating a partial region ($S_{drop}$) of FIG. 4.

Referring to FIG. 5, $t_{r1}$ represents the time when the charging mode is switched to the rest mode, $t_{r2}$ represents the time when the rest mode is switched to the charging mode, and $\Delta t_{resc}$ represents the duration time of the rest mode (e.g., second criterion time, i.e., $t_{r2} - t_{r1}$). $V_{r1}$ represents the voltage value at $t_{r1}$, $V_{r2}$ represents the voltage value at $t_{r2}$, and $\Delta V_{rest}$ represents the voltage change amount (i.e., $V_{r1} - V_{r2}$).

For example, the resistance corresponding to the rest mode may be calculated using formula 1.

<Formula 1>

$$R_{CT} = \frac{\Delta V_{rest}}{I_{CC}}$$

Here, $I_{CC}$ represents the charging current (i.e.,

constant current of the charging c-rate) and $R_{CT}$ represents resistance.

The SOC corresponding to the rest mode is a SOC value that may represent each rest mode, and it is sufficient if it may be determined by the same criterion during the charging process. For example, the SOC corresponding to the rest mode may mean the starting SOC (i.e., the highest SOC) of each rest mode. As another example, the SOC corresponding to the rest mode may mean the SOC at the end point of each rest mode (i.e., the lowest SOC). As yet another example, the SOC corresponding to the rest mode may mean the average SOC during each rest mode.

The criterion c-rate may be preset. For example, the criterion c-rate may be set to a sufficiently low c-rate. Specifically, the criterion c-rate may be set to a c-rate (e.g., 0.33 C) that is low enough that lithium plating is unlikely to occur in a high SOC region during battery charging. As another example, the criterion c-rate may be preset to a lowest c-rate among the c-rates included in the charging protocol.

The resistance profile may be configured to represent the difference between the resistance for each SOC of the reference profile and the resistance for each SOC of the criterion profile.

Specifically, any SOC may be selected, a resistance corresponding to the SOC selected from the reference profile may be determined, and a resistance corresponding to the SOC selected from the criterion profile may be determined. Then, a resistance difference between the resistance of the determined reference profile and the resistance of the criterion profile may be calculated. This process may be repeated for a range in which the SOC range of the reference profile and the SOC range of the criterion profile are common, thereby obtaining a resistance profile.

For example, in the embodiment of FIG. 3, the resistance profile may represent the resistance difference for each SOC between the reference profile corresponding to 3.5 C and the criterion profile corresponding to 0.33 C.

The control unit 130 may be configured to correct the charging protocol by changing the charging c-rate of the charging protocol based on the resistance profile.

Specifically, the control unit 130 may be configured to determine a target SOC section from the resistance profile.

Specifically, the control unit 130 may determine the target SOC section by considering the magnitude of the resistance of the resistance profile and/or the change in the magnitude of the resistance.

For example, the control unit 130 may determine a section in which the resistance of the resistance profile is greater than a predetermined threshold resistance as the target SOC section. Here, the threshold resistance may be preset by considering the type of battery, the type of active material, the composition ratio of the active material, etc. Preferably, the threshold resistance may be preset to a value lower than or equal to the starting resistance of the resistance profile.

For example, in the embodiment of FIG. 3, the control unit 130 may determine a section in which the magnitude of the resistance of the resistance profile P_R is greater than the starting resistance (Rs) as the target SOC section.

As another example, the control unit 130 may determine a section of the resistance profile where the magnitude of the resistance rapidly increases and then rapidly decreases as the target SOC section. In other words, the target SOC section may be determined based on the maximum point of the resistance profile. An embodiment in which the target SOC section is determined based on the maximum point will be described later.

The control unit 130 may be configured to change the target c-rate corresponding to the target SOC section in the charging protocol.

Specifically, the control unit 130 may compare the target SOC section and the charging limit SOC of the charging protocol, and determine the target c-rate based on the comparison result.

More specifically, the control unit 130 may compare the upper limit of the target SOC section with the charging limit SOC, and determine the target c-rate based on the comparison result.

The control unit 130 may determine a charging limit SOC exceeding the upper limit of the target SOC section, and determine a charging c-rate corresponding to the determined charging limit SOC as the target c-rate. If there are multiple charging limit SOCs exceeding the upper limit of the target SOC section, the control unit 130 may determine a charging c-rate corresponding to the minimum SOC among the determined plurality of charging limit SOCs as the target c-rate.

For example, in the embodiment of FIG. 2, when the target SOC section is determined as SOC 0 to 10%, the control unit 130 may individually compare SOC 10%, which is the upper limit of the target SOC section, with the plurality of charging limit SOCs included in the charging protocol. The charging limit SOC exceeding 10% may be determined as 15%, 25%, 55%, 80%, and 100%. The control unit 130 may determine 3.5 C, which is the charging c-rate corresponding to the minimum SOC, 15%, among the determined plurality of charging limit SOC, as the target c-rate.

Furthermore, if there is a charging limit SOC that is lower than or equal to the upper limit of the target SOC section, the control unit 130 may determine the charging limit SOC lower than or equal to the upper limit of the target SOC section, and also determine the charging c-rate corresponding to the determined charging limit SOC as the target c-rate. That is, if there is a charging limit SOC that is lower than or equal to the upper limit of the target SOC section, the target c-rate may be determined in plurality.

For example, in the embodiment of FIG. 2, when the target SOC section is determined as SOC 0 to 20%, the control unit 130 may individually compare SOC 20%, which is the upper limit of the target SOC section, with the plurality of charging limit SOC included in the charging protocol. The charging limit SOC exceeding 20% may be determined as 25%, 55%, 80%, and 100%. The control unit 130 may determine 2.5 C, which is a charging c-rate corresponding to the minimum SOC 25%, among the determined plurality of charging limit SOCs, as the target c-rate. In addition, since there is a charging limit SOC (15%) lower than or equal to SOC 20%, the control unit 130 may also determine 3.5 C, which is a charging c-rate corresponding to the charging limit SOC 15%, as the target c-rate. That is, the control unit 130 may determine 2.5 C and 3.5 C among the charging c-rates of the charging protocol as the target c-rate.

As another example, the control unit 130 may determine the target c-rate based on the result of individually comparing the lower limit of the target SOC section with the charging limit SOC of the charging protocol. Specifically, the control unit 130 may determine a charging limit SOC equal to or greater than the lower limit of the target SOC section, and determine a charging c-rate corresponding to the determined charging limit SOC as the target c-rate. If there are a plurality of determined charging limit SOCs, the charging c-rate corresponding to the charging limit SOC having the smallest SOC may be determined as the target c-rate.

As yet another example, the control unit 130 may determine the target c-rate based on the result of individually comparing the upper limit and the lower limit of the target SOC section with the charging limit SOC of the charging protocol. As in the previous embodiment, the control unit 130 may determine the charging c-rate corresponding to the charging limit SOC equal to or greater than the lower limit of the target SOC section and the charging c-rate corresponding to the charging limit SOC equal to or lower than the upper limit of the target SOC section as the target c-rate.

If multiple target c-rates corresponding to the target SOC section are determined, the control unit 130 may be configured to change all of the plurality of target c-rates.

Preferably, the control unit 130 may be configured to reduce the target c-rate. That is, the control unit 130 may reduce the target c-rate for the target SOC section.

In one embodiment, the control unit 130 may reduce the target c-rate to any one of the charging c-rates included in the charging protocol. Preferably, the control unit 130 may reduce the target c-rate to a lowest charging c-rate among the charging c-rates included in the charging protocol.

In the embodiment of FIG. 2, it is assumed that the target SOC section is SOC 0 to 10%. Since the lowest charging c-rate among the charging c-rates included in the charging protocol is 0.33 C, the control unit 130 may reduce the target c-rate corresponding to the target SOC section to 0.33 C. That is, the c-rate corresponding to the section of SOC 0 to 10% (0% or more and 10% or less) is 0.33 C, and the c-rate corresponding to the section of SOC 10 to 15% (10% or more and 15% or less) is 3.5 C. In another embodiment, the control unit 130 may reduce the target c-rate to a preset criterion c-rate. Here, the criterion c-rate is a c-rate that is experimentally or theoretically set so that lithium plating does not occur. Preferably, the criterion c-rate may be set to a value smaller than the charging c-rate corresponding to the target SOC section.

For example, the criterion c-rate may be set to 0.5 C or less. Preferably, the criterion c-rate may be set to 0.33 C or less.

As another example, the criterion c-rate may be set to correspond to the SOC of the battery. Specifically, the criterion c-rate may be preset to a maximum c-rate at which lithium plating does not occur in the charging process of the target SOC section.

When charging a battery at a high c-rate, the overvoltage of the battery may increase rapidly. When the overvoltage of the battery increases rapidly, the point in time when the voltage of the battery reaches the charging upper limit voltage is advanced compared to the case where there is no overvoltage. In addition, when the point in time when the voltage of the battery reaches the charging upper limit voltage is advanced, the capacity retention rate of the battery decreases. In other words, if rapid charging is repeated, the problem of accelerated degradation of the battery may occur.

When charging a battery at the same c-rate, the size of the overvoltage occurring in a relatively high SOC region tends to be greater than the size of the overvoltage occurring in a relatively low SOC region. In addition, when charging a battery using the same c-rate, there tends to be a high risk of lithium plating, in which lithium metal is deposited on the negative electrode, in a relatively high SOC region.

And, whether this lithium plating phenomenon occurs may be determined based on whether the resistance of the battery changes rapidly.

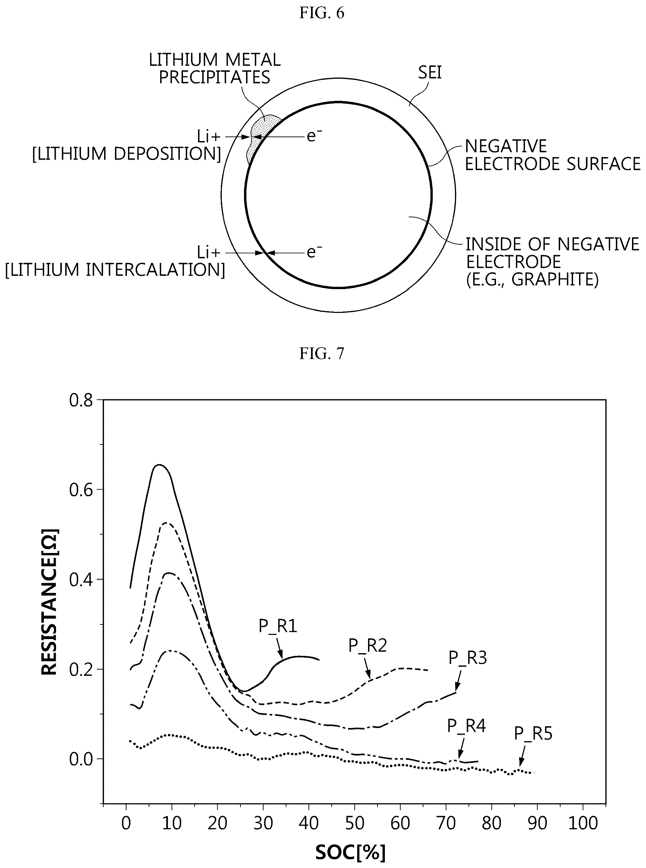

FIG. 6 is a drawing illustrating an example of a state in which lithium metal precipitates are formed on a negative electrode of a battery. Referring to Fig. 6, the relationship between the lithium plating phenomenon and the resistance of the battery is explained.

Specifically, the battery is charged through a lithium intercalation reaction in which lithium ions are inserted from the positive electrode to the negative electrode. In addition, electrons are consumed along with the lithium intercalation reaction. However, when a lithium plating phenomenon in which lithium metal is deposited on the negative electrode occurs, the lithium intercalation reaction and the lithium plating reaction competitively consume electrons. That is, when lithium metal precipitates are formed on the negative electrode, the electron movement path may be expanded compared to the case where they are not. Accordingly, the charge transfer resistance may be rapidly reduced. More specifically, the interfacial resistance is the total resistance due to the SEI (Solid Electrolyte Interphase), charge transfer, and double layer, and is greatly affected by charge accumulation on the positive electrode surface and the negative electrode surface of the battery cell. Since the resistance due to the lithium metal precipitates formed on the negative electrode surface is synthesized in parallel with the interfacial resistance, the interfacial resistance may decrease as the lithium metal precipitates increase. Therefore, when creating a rapid charging protocol, a method may be adopted in which a high charging c-rate is used at the start of charging and the charging c-rate is gradually lowered as the SOC of the battery increases.

However, for some batteries, when charging using a high c-rate, the resistance increases rapidly in the low SOC section, and the structure of the positive electrode may collapse. In addition, since the metal of the positive electrode active material may be detected on the surface of the negative electrode, charging using a high c-rate may not be desirable in terms of the battery's capacity retention rate even in the low SOC region.

For example, in the case of a manganese-rich battery, it was found that when charging using a high c-rate, the resistance in the low SOC section increased rapidly and the amount of manganese detected on the negative electrode surface increased. This is because the structure of the positive electrode of the manganese-rich battery collapsed in the charging process using a high c-rate, and the extracted manganese was detected on the negative electrode surface.

That is, since the charging protocol generating apparatus 100 may correct the charging protocol in a way that reduces the c-rate corresponding to the target SOC section, it has the advantage of being able to generate a charging protocol that may further increase the life and safety of the battery.

Meanwhile, the control unit 130 included in the charging protocol generating apparatus 100 may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the charging protocol generating apparatus 100 may further include a storage unit 140. The storage unit 140 may store data necessary for operation and function of each component of the charging protocol generating apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Specifically, the storage unit 140 may store information necessary for the control unit 130 to diagnose the state of the battery. For example, the storage unit 140 may store a reference profile, a criterion profile, etc. In addition, the control unit 130 may access the storage unit 140 to obtain information necessary for diagnosing the state of the battery. For example, the charging protocol obtained by the protocol obtaining unit 110 is stored in the storage unit 140, and the control unit 130 may access the storage unit 140 to obtain the stored charging protocol. The resistance profile obtained by the profile obtaining unit 120 is stored in the storage unit 140, and the control unit 130 may access the storage unit 140 to obtain the stored resistance profile.

Below, a specific embodiment of determining a target SOC section based on a peak of a resistance profile according to an embodiment of the present disclosure is described.

For example, the control unit 130 may be configured to detect at least one peak in the resistance profile and determine a target SOC section based on the detected peak.

Specifically, the resistance profile may include at least one peak. Here, the peak means a point showing an upward convex shape among points where the instantaneous change rate of the resistance for SOC is 0. In other words, the peak means the maximum point of the resistance profile. Based on the peak, the instantaneous change rate of the resistance for SOC on the low SOC region side is positive, and the instantaneous change rate of the resistance for SOC on the high SOC region side is negative. The control unit 130 may detect at least one peak included in the resistance profile.

Specifically, the control unit 130 may be configured to determine a target peak having the smallest corresponding SOC among the at least one peak.

In the embodiment of FIG. 3, the control unit 130 may detect two peaks (Peak1, Peak2) included in the resistance profile. Then, the control unit 130 may determine a peak with a smallest corresponding SOC among the two peaks (Peak1, Peak2) and determine the determined peak as a target peak. Specifically, since the SOC corresponding to the peak (Peak1) is about 10% and the SOC corresponding to the peak (Peak2) is about 35%, the control unit 130 may determine the peak (Peak1) with a smaller corresponding SOC as the target peak (TP).

The control unit 130 may be configured to determine a SOC section including the target SOC of the target peak as the target SOC section.

Specifically, the upper limit and lower limit of the target SOC section may be determined in consideration of the target SOC. For example, the control unit 130 may determine the upper limit of the target SOC section to be a value higher than or equal to the target SOC. And, the control unit 130 may determine the lower limit of the target SOC section to be a value lower than or equal to the target SOC.

The control unit 130 may be configured to determine a SOC section within a predetermined range from the target SOC as the target SOC section.

For example, the control unit 130 may determine a SOC section within a predetermined range in a negative direction from the target SOC as the target SOC section. That is, the control unit 130 may determine an upper limit of the target SOC section as the target SOC. Preferably, the lower limit of the target SOC section may be determined as an allowable minimum SOC (e.g., 0%) or a lower limit of the SOC range in which charging is performed.

In the embodiment of FIG. 3, the control unit 130 may determine a SOC section in which SOC 0% is the lower limit and the target SOC (TP, approximately 10%) is the upper limit as the target SOC section.

As another example, the control unit 130 may determine a SOC section that falls within a predetermined range in the positive and negative directions from the target SOC as the target SOC section. Preferably, the lower limit of the target SOC section may be determined as the allowable minimum SOC (e.g., 0%) or the lower limit of the SOC range in which charging is performed.

In the embodiment of FIG. 3, the control unit 130 may set SOC 0% as the lower limit and determine a SOC section within a 10% range in a positive direction from the target SOC (approximately 10%) as the target SOC section.

On the other hand, if only the SOC section falling within a predetermined range in the positive direction from the target SOC is determined as the target SOC section, the charging c-rate will not be changed for the SOC section lower than the target SOC. In this case, only the charging c-rate of the middle SOC section is changed in the charging protocol, and there is a problem that the structure of the positive electrode may collapse in the low SOC section where the charging c-rate is not changed, which is not desirable.

That is, the charging protocol generating apparatus 100 may set a target SOC section in which the charging c-rate should be reduced by considering the resistance of the battery in order to prevent lithium plating from occurring in the charging process. Therefore, according to the charging protocol generated by the charging protocol generating apparatus 100, unnecessary precipitation of lithium metal can be prevented in the charging process of the battery, and collapse of the positive electrode structure can be prevented.

FIG. 7 is a drawing illustrating a plurality of resistance profiles P_R1, P_R2, P_R3, P_R4, P_R5 according to an embodiment of the present disclosure.

In the embodiment of FIG. 7, the horizontal axis (X-axis) represents SOC, and the vertical axis (Y-axis) represents resistance.

Referring to FIG. 7, the first resistance profile P_R1 is a resistance profile corresponding to a charging c-rate of 3.5 C. The second resistance profile P_R2 is a resistance profile corresponding to a charging c-rate of 2.5 C. The third resistance profile P_R3 is a resistance profile corresponding to a charging c-rate of 1 C. The fourth resistance profile P_R4 is a resistance profile corresponding to a charging c-rate of 0.5 C. The fifth resistance profile P_R5 is a resistance profile corresponding to a charging c-rate of 0.33 C.

If there are multiple resistance profiles, the control unit 130 may determine a target SOC section based on any one of the plurality of resistance profiles P_R1, P_R2, P_R3, P_R4, P_R5.

For example, the control unit 130 may be configured to determine a target SOC section from a resistance profile having the largest corresponding charging c-rate among the plurality of resistance profiles P_R1, P_R2, P_R3, P_R4, P_R5.

Referring to FIG. 7, among the plurality of resistance profiles P_R1, P_R2, P_R3, P_R4, P_R5, the resistance profile having the largest corresponding charging c-rate is the first resistance profile P_R1. The control unit 130 may be configured to determine the target SOC section from the first resistance profile P_R1.

In FIG. 7, as the corresponding charging c-rate increases, the target SOC of the target peak included in the resistance profile tends to decrease. Therefore, if the control unit 130 determines the target SOC section using the resistance profile having the largest corresponding charging c-rate, the target SOC section of the narrowest section among the target SOC sections that can be determined based on the plurality of resistance profiles P_R1, P_R2, P_R3, P_R4, P_R5 may be determined. That is, since the target peak having the smallest corresponding SOC is determined among the plurality of target peaks that can be selected and the target SOC section is determined based on the determined target peak, the target SOC section in which the charging c-rate is changed may be minimized. In addition, since the target SOC section in which the charging c-rate decreases is determined to be the minimum, the battery may be charged faster using the generated charging protocol rather than using a charging protocol based on another resistance profile.

That is, since the charging protocol generating apparatus 100 changes the c-rate for the minimum target SOC section by considering a plurality of resistance profiles, it may generate a charging protocol that prevents battery degradation and enables rapid charging.

Below, a specific embodiment in which a charging protocol is set based on a reference profile is described. That is, a specific embodiment in which a charging limit SOC corresponding to a charging c-rate is determined based on a reference profile is described.

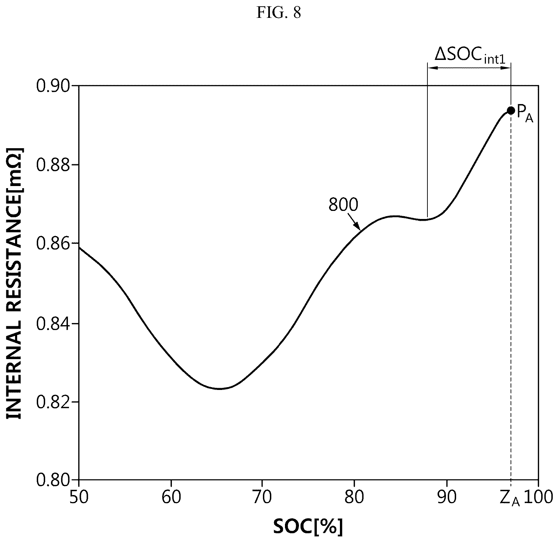

FIG. 8 to FIG. 10 are drawings illustrating reference profiles 800, 900, 1000 obtained during a charging process under different charging conditions.

FIG. 8 is a diagram illustrating an example of a first reference profile 800 obtained by performing a charging process on a battery under the first charging condition where the charging c-rate is 0.5 C and the battery temperature (e.g., the temperature measured at the start of the charging process) is 25°C. $\Delta SOC_{int1}$ is the SOC range of interest (e.g., 88 to 97%) associated with the first charging condition.

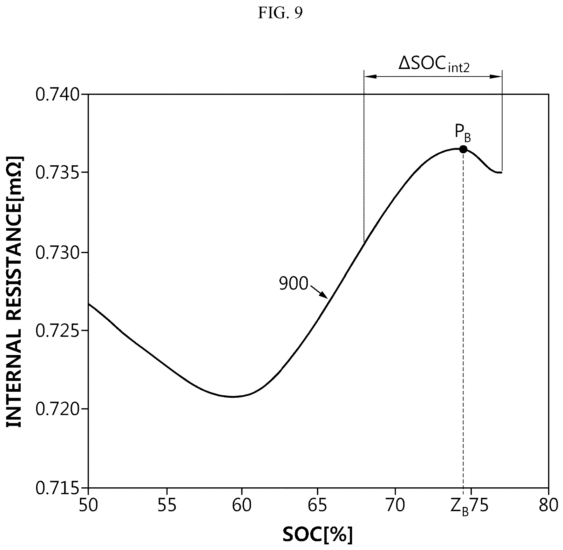

FIG. 9 is a diagram illustrating an example of a second reference profile 900 obtained by performing a charging process on a battery under the second charging condition where the charging c-rate is 2 C and the battery temperature is 25°C. $\Delta SOC_{int2}$ is the SOC range of interest (e.g., 68 to 77%) associated with the second charging condition.

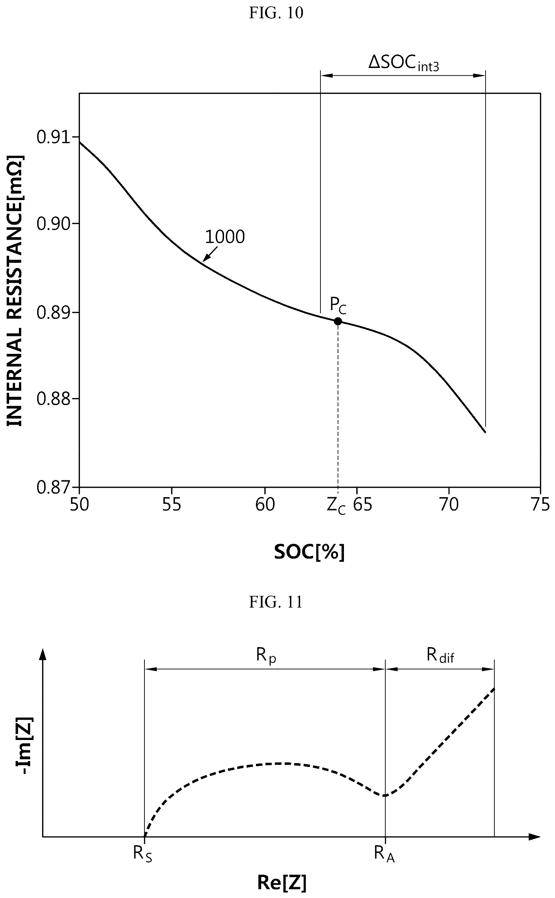

FIG. 10 is a diagram illustrating an example of a third reference profile 1000 obtained by performing a charging process on a battery under the third charging condition where the charging c-rate is 2 C and the battery temperature is 10°C. $\Delta SOC_{int3}$ is the SOC range of interest (e.g., 63 to 72%) associated with the third charging condition.

Here, the SOC range of interest may be preset to correspond to each charging condition. Since the SOC range of interest is for determining the charging limit SOC corresponding to the charging c-rate, it may be preset to a high SOC section.

The charging protocol may be configured so that a corresponding charging limit SOC is set for each charging c-rate based on the change pattern of resistance according to an increase in SOC of the reference profile.

Referring to FIG. 8, the resistance only shows an increasing pattern as the SOC increases in the SOC range of interest ($\Delta SOC_{int1}$). That is, the first derivative of the first reference profile 800 in the SOC range of interest ($\Delta SOC_{int1}$) is positive. In this way, when a continuous increase pattern of the resistance is confirmed as the SOC increases, the control unit 130 may determine the SOC at the end point ($P_A$) of the first reference profile 800 as the charging limit SOC ($Z_A$). That is, the charging limit SOC ($Z_A$) may be equal to the upper limit SOC of the SOC range of interest ($\Delta SOC_{int1}$).

Referring to FIG. 9, as the SOC increases in the SOC range of interest ($\Delta SOC_{int2}$), the resistance increases and then decreases. If the increase section and the decrease section of the resistance are adjacent in this way, the control unit 130 may determine the SOC at the maximum point ($P_B$) included in the SOC range of interest ($\Delta SOC_{int2}$) of the second reference profile 900 as the charging limit SOC ($Z_B$). Specifically, the control unit 130 may obtain the first differential profile by firstly differentiating the second reference profile 900 with respect to the SOC. The control unit 130 may determine the SOC at the point where the differential resistance value (dR/dSOC) in the first differential profile switches from a positive number to a negative number as the SOC increases, as the charging limit SOC ($Z_B$). That is, the charging limit SOC ($Z_B$) may be equal to the SOC corresponding to the maximum point ($P_B$) included in the SOC range of interest ($\Delta SOC_{int2}$).

Referring to FIG. 10, as SOC increases in the SOC range of interest ($\Delta SOC_{int3}$), the resistance only shows a decreasing pattern. If a continuous decreasing pattern of resistance is confirmed in this way as SOC increases, the control unit 130 may determine the SOC at the inflection point ($P_C$) of the third reference profile 1000 as the charging limit SOC ($Z_C$). Specifically, the control unit 130 may obtain a second differential profile by secondarily differentiating the third reference profile 1000 with respect to SOC. The control unit 130 may determine the SOC at the point where the second differential resistance value ($d^2R/dSOC^2$) in the second differential profile switches from a positive number to a negative number as SOC increases, as the charging limit SOC ($Z_C$). That is, the charging limit SOC ($Z_C$) may be equal to the SOC corresponding to the inflection point ($P_C$) included in the SOC range of interest ($\Delta SOC_{int3}$).

The charging limit SOCs ($Z_A$, $Z_B$, $Z_C$) illustrated in FIGS. 8 to 10 represent the maximum SOC at which lithium metal may not be deposited on the negative electrode surface when the battery is charged at the corresponding charging c-rate, respectively. That is, when the battery is charged at the corresponding charging c-rate, a lithium plating phenomenon may occur in a SOC section higher than the charging limit SOC. Therefore, the charging limit SOC for each of the plurality of c-rates may be determined, and a charging protocol in which the corresponding c-rate and the charging limit SOC are mapped may be set.

Below, a specific example of determining the second criterion time based on EIS data is described.

FIG. 11 is a drawing illustrating an example of a complex impedance curve of a battery.

EIS data may be obtained by repeating the process of measuring the complex impedance of the battery by applying an AC signal to the battery. That is, FIG. 11 may be a Nyquist plot showing the impedance change of the battery according to the frequency change of the AC signal. Meanwhile, the process of obtaining the complex impedance curve of the battery is performed once before the charging process for the battery is initiated, and the AC signal is applied to the battery for only a short time, so it causes little damage to the battery.

$R_S$ represents the ohmic resistance of the battery cell, and is hardly affected by the presence or absence of lithium deposition. $R_p$ represents the charge transfer resistance of the battery. $R_A$ represents the internal resistance of the battery, and $R_A = R_S + R_p$.

The criterion frequency may be determined based on the complex impedance curve. And, the second criterion time may be determined based on the criterion frequency.

Specifically, the complex impedance curve may be divided into a convex section and an inclined section.

Here, the convex section may be a section related to current movement resistance. The inclined section may be a section of a straight-line shape extending to the right side of the convex section, and may be a section related to the diffusion resistance ($R_{dif}$) of the battery. The frequency of the AC signal applied at the boundary point ($R_A$) of the convex section and the inclined section may be determined as the criterion frequency.

Since the boundary point ($R_A$) is related to the charge transfer resistance, if the frequency of the AC signal applied at the boundary point ($R_A$) is determined as the criterion frequency, the rest mode may continue for an appropriate time required to observe the voltage change due to the internal resistance of the battery. Therefore, it is possible to prevent the deterioration of the accuracy of the internal resistance estimation due to the second criterion time being set too short or too long.

The second criterion time may be determined based on the criterion frequency. Specifically, the second criterion time and the criterion frequency may have a predetermined negative corresponding relationship. For example, using the formula 2, the second criterion time may be determined based on the criterion frequency.

$$<\text{Formula 2}>$$

$$\Delta t_{R2} = \frac{1}{f_{i-d}} \times w$$

Here, $f_{i-d}$ represents the criterion frequency, w represents a predetermined margin constant (preferably a constant greater than or equal to 1), and $\Delta t_{R2}$ represents the second criterion time.

That is, the second criterion time may be set to be equal to or greater than the value obtained by multiplying the reciprocal of the criterion frequency ($f_{i-d}$) by the margin constant (w).

The charging protocol generating apparatus 100 according to the present disclosure may be applied to a battery management system (BMS). That is, the BMS according to the present disclosure may include the charging protocol generating apparatus 100 described above. In this configuration, at least some of components of the charging protocol generating apparatus 100 may be implemented by supplementing or adding functions of the components included in a conventional BMS. For example, the protocol obtaining unit 110, the profile obtaining unit 120 and the control unit 130 of the charging protocol generating apparatus 100 may be implemented as components of the BMS.

A server according to another embodiment of the present disclosure may include the charging protocol generating apparatus 100.

The server may be connected to at least one BMS to be able to communicate with it via wired and/or wireless communication. In addition, the server may be connected to be able to communicate with a device capable of controlling charging of a battery, such as a charging station as well as a BMS. In addition, the server may be connected to be able to communicate with at least one user terminal. In addition, the server may be connected to be able to communicate with a battery manufacturing system that manufactures the battery and sets initial data for the battery.

The server may receive a charging protocol for the battery from the outside. For example, the server may receive a charging protocol from a BMS connected to the battery, a battery manufacturing system, or a user terminal.

And, the server may receive a reference profile from the outside and directly generate a resistance profile based on the received reference profile and a preset criterion profile. As another example, the server may also receive a resistance profile from the outside.

The server may correct the charging protocol by changing the charging c-rate of the charging protocol based on the generated resistance profile. Then, the server may transmit the corrected charging protocol to a device capable of controlling the charging of the battery, such as a BMS, so that the battery can be rapidly charged effectively.

A battery management device according to still another embodiment of the present disclosure may be configured to receive the corrected charging protocol from the charging protocol generating apparatus 100 and control charging of a charging target battery based on the corrected charging protocol.

For example, the battery management device may be connected to the charging protocol generating apparatus 100 via wires and/or wirelessly, and receive the corrected charging protocol from the charging protocol generating apparatus 100.

As another example, the battery management device may include the charging protocol generating apparatus 100.

The battery management device may determine whether the SOC of the charging target battery is included in the target SOC section. Specifically, the battery management device may determine whether the SOC of the charging target battery is less than or equal to the upper limit of the target SOC section and greater than or equal to the lower limit. If the SOC of the charging target battery is included in the target SOC section, the battery management device may control the charging target battery to be charged at a charging c-rate corresponding to the target SOC section. Conversely, if the SOC of the charging target battery is not included in the target SOC section, the battery management device may compare the charging limit SOC of the corrected charging protocol with the SOC of the charging target battery, and determine the charging c-rate based on the comparison result. The battery management device may determine the charging limit SOC that is greater than or equal to the SOC of the charging target battery. Then, the battery management device may control the charging target battery to be charged at the charging c-rate corresponding to the determined charging limit SOC. If there are multiple charging limit SOCs that are greater than or equal to the SOC of the charging target battery, the battery management device may control the charging target battery to be charged at the maximum charging c-rate among the charging c-rates corresponding to each of the plurality of charging limit SOCs.

Additionally, the battery management device may be provided in a battery pack. That is, the battery pack according to the present disclosure may include the above-described battery management device and at least one battery cell. Additionally, the battery pack may further include electrical components (relays, fuses, etc.) and a case.

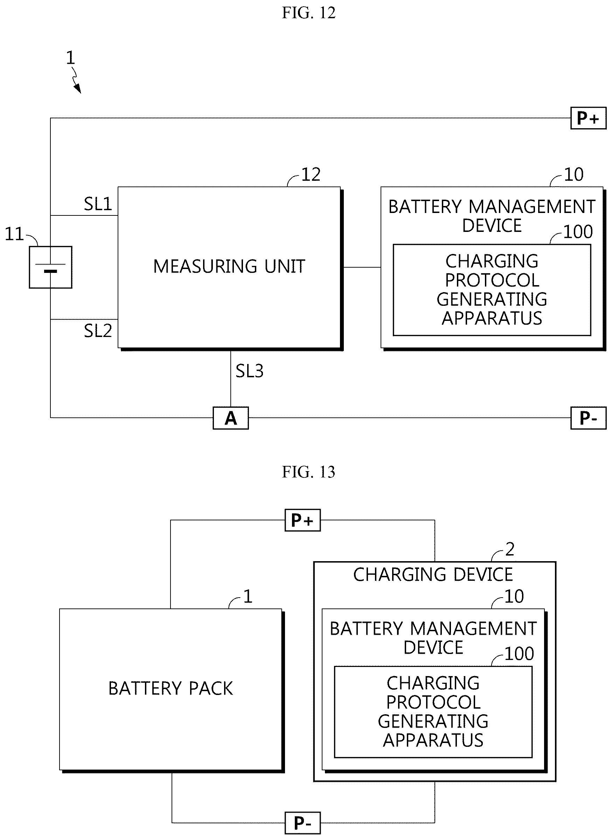

FIG. 12 is a diagram schematically showing a battery pack 1 including the battery management device 10 according to still another embodiment of the present disclosure.

The positive electrode terminal of the battery 11 may be connected to the positive electrode terminal P+ of the battery pack 1, and the negative electrode terminal of the battery 11 may be connected to the negative electrode terminal P- of the battery pack 1.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 and calculate the charging amount. Also, the measuring unit 12 may measure the discharging current of the battery 11 through the third sensing line SL3 and calculate the discharging amount.

One end of a charging and discharging unit (not shown) may be connected to the positive electrode terminal P+ of the battery pack 1, and the other end may be connected to the negative electrode terminal P- of the battery pack 1. Therefore, the positive electrode terminal of the battery 11, the positive electrode terminal P+ of the battery pack 1, the charging and discharging unit, the negative electrode terminal P- of the battery pack 1, and the negative electrode terminal of the battery 11 may be electrically connected.

For example, the charging and discharging unit may be a charging device, or may be a motor of an electric vehicle that receives power from the battery 11.

Additionally, the battery management device 10 may be provided in the charging device. For example, the charging device according to the present disclosure includes the battery management device 10 described above, and the charging device may be connected to a battery pack.

Meanwhile, in FIG. 12, the charging protocol generating apparatus 100 is illustrated as being included in the battery management device 10, but the charging protocol generating apparatus 100 may exist outside the battery management device 10 and may be connected to the battery management device 10 by wire and/or wirelessly.

FIG. 13 is a drawing illustrating an exemplary configuration of a charging device 2 including a battery management device 10 according to still another embodiment of the present disclosure.

One end of the charging device 2 may be connected to a positive electrode terminal P+ of the battery pack 1, and the other end of the charging device 2 may be connected to a negative electrode terminal P- of the battery pack 1. The battery management device 10 of the charging device 2 may be configured to control charging of the battery pack 1 using a charging protocol generated by the charging protocol generating apparatus 100.

Meanwhile, in FIG. 13, the charging protocol generating apparatus 100 is illustrated as being included in the battery management device 10, but the charging protocol generating apparatus 100 may exist outside the charging device 2 and/or the battery management device 10, and may be connected to the battery management device 10 by wire and/or wirelessly. For example, the charging protocol generating apparatus 100 may exist outside the charging device 2, and may be connected to the battery management device 10 by wire and/or wirelessly. The battery management device 10 may receive a charging protocol from the charging protocol generating apparatus 100, and control charging of the battery pack 1 based on the received charging protocol.

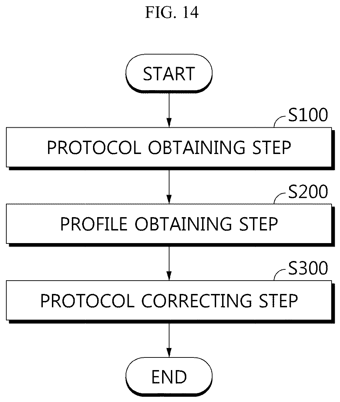

FIG. 14 is a diagram schematically showing a charging protocol generating method according to still another embodiment of the present disclosure.

Referring to FIG. 14, the charging protocol generating method may include a protocol obtaining step (S 100), a profile obtaining step (S200), and a protocol correcting step (S300).

Preferably, each step of the charging protocol generating method may be performed by the charging protocol generating apparatus 100. Hereinafter, for convenience of explanation, content that overlaps with the content described above will be omitted or briefly described.

The protocol obtaining step (S100) is a step of obtaining a charging protocol that represents a corresponding relationship between the SOC of the battery and the charging c-rate, and may be performed by the protocol obtaining unit 110.

The profile obtaining step (S200) is a step of obtaining a resistance profile based on a reference profile representing a corresponding relationship between the SOC and resistance of a battery in a charging process according to a charging c-rate and a criterion profile corresponding to a preset criterion c-rate, and may be performed by the profile obtaining unit 120.

The resistance profile may be configured to represent the difference between a resistance for each SOC of the reference profile and a resistance for each SOC of the criterion profile.

Specifically, any SOC may be selected, a resistance corresponding to the selected SOC in the reference profile may be determined, and a resistance corresponding to the selected SOC from the criterion profile may be determined. Then, a resistance difference between the determined resistance of the reference profile and the resistance of the criterion profile may be calculated. This process may be repeated for a range in which the SOC range of the reference profile and the SOC range of the criterion profile are common, thereby obtaining a resistance profile.

The protocol correcting step (S300) is a step of correcting the charging protocol by changing the charging c-rate of the charging protocol based on the resistance profile, and may be performed by the control unit 130.

The control unit 130 may be configured to determine the target SOC section from the resistance profile. Specifically, the control unit 130 may determine the target SOC section by considering the magnitude of the resistance of the resistance profile and/or the change in the magnitude of the resistance.

The control unit 130 may be configured to change a target c-rate corresponding to a target SOC section in the charging protocol. Specifically, the control unit 130 may compare the target SOC section with the charging limit SOC of the charging protocol, and determine the target c-rate based on the comparison result. In addition, the control unit 130 may be configured to decrease the target c-rate.

For example, the control unit 130 may reduce the target c-rate to any one of the charging c-rates included in the charging protocol. Preferably, the control unit 130 may reduce the target c-rate to a lowest charging c-rate among the charging c-rates included in the charging protocol.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

1: battery pack
2: charging device
10: battery management device
11: battery
12: measuring unit
100: charging protocol generating apparatus
110: protocol obtaining unit
120: profile obtaining unit
130: control unit
140: storage unit

**Claims**

1. A charging protocol generating apparatus, comprising:

   a protocol obtaining unit configured to obtain a charging protocol representing a corresponding relationship between a charging c-rate and a charging limit SOC of a battery;
   a profile obtaining unit configured to obtain a resistance profile based on a reference profile representing a corresponding relationship between SOC and resistance of the battery in a charging process according to the charging c-rate and a criterion profile corresponding to a preset criterion c-rate; and
   a control unit configured to correct the charging protocol by changing the charging c-rate of the charging protocol based on the resistance profile.

2. The charging protocol generating apparatus according to claim 1,
   wherein the control unit is configured to determine a target SOC section in the resistance profile and change a target c-rate corresponding to the target SOC section in the charging protocol.

3. The charging protocol generating apparatus according to claim 2,
   wherein the control unit is configured to reduce the target c-rate.

4. The charging protocol generating apparatus according to claim 2,
   wherein the control unit is configured to detect at least one peak in the resistance profile and determine the target SOC section based on the detected peak.

5. The charging protocol generating apparatus according to claim 4,
   wherein the control unit is configured to determine a target peak having a smallest corresponding SOC among the at least one peak and determine a SOC section including a target SOC of the target peak as the target SOC section.

6. The charging protocol generating apparatus according to claim 5,
   wherein the control unit is configured to determine a SOC section within a predetermined range from the target SOC as the target SOC section.

7. The charging protocol generating apparatus according to claim 4,
   wherein when there are a plurality of charging c-rates, the control unit is configured to determine the target SOC section based on one of a plurality of resistance profiles corresponding to the plurality of charging c-rates.

8. The charging protocol generating apparatus according to claim 7,
   wherein the control unit is configured to determine the target SOC section in a resistance profile having a largest corresponding charging c-rate among the plurality of resistance profiles.

9. The charging protocol generating apparatus according to claim 1,

   wherein the charging process is configured to alternately repeat a charging mode and a rest mode, and
   wherein the reference profile is configured to represent a corresponding relationship between a resistance calculated based on a voltage change amount during each rest mode and a SOC corresponding to each rest mode.

10. The charging protocol generating apparatus according to claim 9,
   wherein the charging protocol is configured to set a corresponding charging limit SOC for each charging c-rate based on a change pattern of the resistance according to an increase in SOC of the reference profile.

11. The charging protocol generating apparatus according to claim 1,
wherein the resistance profile is configured to represent a difference between a resistance for each SOC of the reference profile and a resistance for each SOC of the criterion profile.

12. A server, comprising the charging protocol generating apparatus according to any one of claims 1 to 11.

13. A battery management device configured to receive a corrected charging protocol from the charging protocol generating apparatus according to any one of claims 1 to 11, and to control charging of a charging target battery based on the corrected charging protocol.

14. A charging protocol generating method, comprising:

a protocol obtaining step of obtaining a charging protocol representing a corresponding relationship between a SOC of a battery and a charging c-rate;
a profile obtaining step of obtaining a resistance profile based on a reference profile representing a corresponding relationship between the SOC and a resistance of the battery in a charging process according to the charging c-rate and a criterion profile corresponding to a preset criterion c-rate; and
a protocol correcting step of correcting the charging protocol by changing the charging c-rate of the charging protocol based on the resistance profile.

FIG. 1

100

CHARGING PROTOCOL GENERATING APPARATUS

PROTOCOL OBTAINING UNIT    110

PROFILE OBTAINING UNIT    120

CONTROL UNIT    130

STORAGE UNIT    140

FIG. 2

| CHARGING C-RATE | CHARGING LIMIT SOC[%] |
|:---:|:---:|
| 3.5 | 15 |
| 2.5 | 25 |
| 1 | 55 |
| 0.5 | 80 |
| 0.33 | 100 |

FIG. 3

FIG. 4

FIG. 5

FIG. 6

FIG. 7

FIG. 8

FIG. 9

FIG. 10

FIG. 11

FIG. 12

FIG. 13

FIG. 14

## INTERNATIONAL SEARCH REPORT

International application No.

**PCT/KR2025/003657**

| A. | CLASSIFICATION OF SUBJECT MATTER |
|---|---|

**H02J 7/00**(2006.01)i; **G01R 31/382**(2019.01)i; **G01R 31/389**(2019.01)i; **H01M 10/44**(2006.01)i

According to International Patent Classification (IPC) or to both national classification and IPC

| B. | FIELDS SEARCHED |
|---|---|

Minimum documentation searched (classification system followed by classification symbols)

H02J 7/00(2006.01); G01R 31/3835(2019.01); G01R 31/389(2019.01); G05B 23/02(2006.01); H01M 10/052(2010.01); H01M 10/48(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), SOC(state of charge), c-rate(current rate), 프로토콜(protocol), 저항 프로파일(resistance profile), 보정(compensation)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2024-0066905 A (LG ENERGY SOLUTION, LTD.) 16 May 2024 (2024-05-16)<br>paragraphs [0037]-[0157]; claims 1-15; and figures 1-16 | 1-14 |
| A | KR 10-2023-0050107 A (LG ENERGY SOLUTION, LTD.) 14 April 2023 (2023-04-14)<br>paragraphs [0028]-[0102]; claims 1-12; and figures 1-7 | 1-14 |
| A | KR 10-2020-0049596 A (HYUNDAI MOTOR COMPANY et al.) 08 May 2020 (2020-05-08)<br>paragraphs [0040]-[0173]; claims 1-20; and figures 1-22 | 1-14 |
| A | WO 2022-272244 A1 (ATIEVA, INC.) 29 December 2022 (2022-12-29)<br>paragraphs [0031]-[0058]; claims 1-24; and figures 1-5 | 1-14 |
| A | US 2017-0070061 A1 (TEXAS INSTRUMENTS INCORPORATED) 09 March 2017 (2017-03-09)<br>paragraphs [0043]-[0089]; claims 1-25; and figures 4-8 | 1-14 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **04 August 2025** | **06 August 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

| International application No. |
|---|
| **PCT/KR2025/003657** |

| Patent document cited in search report | | | Publication date (day/month/year) | Patent family member(s) | | | Publication date (day/month/year) |
|---|---|---|---|---|---|---|---|
| KR | 10-2024-0066905 | A | 16 May 2024 | CN | 118613986 | A | 06 September 2024 |
| | | | | EP | 4472015 | A1 | 04 December 2024 |
| | | | | KR | 10-2767066 | B1 | 11 February 2025 |
| | | | | WO | 2024-101832 | A1 | 16 May 2024 |
| KR | 10-2023-0050107 | A | 14 April 2023 | CN | 116670525 | A | 29 August 2023 |
| | | | | EP | 4254719 | A1 | 04 October 2023 |
| | | | | EP | 4254719 | A4 | 21 August 2024 |
| | | | | JP | 2024-501975 | A | 17 January 2024 |
| | | | | JP | 7537839 | B2 | 21 August 2024 |
| | | | | US | 2024-0039317 | A1 | 01 February 2024 |
| | | | | WO | 2023-059165 | A1 | 13 April 2023 |
| KR | 10-2020-0049596 | A | 08 May 2020 | US | 11283103 | B2 | 22 March 2022 |
| | | | | US | 2020-0136173 | A1 | 30 April 2020 |
| WO | 2022-272244 | A1 | 29 December 2022 | CN | 117529866 | A | 06 February 2024 |
| | | | | EP | 4360187 | A1 | 01 May 2024 |
| | | | | EP | 4360187 | A4 | 14 May 2025 |
| | | | | JP | 2024-526032 | A | 17 July 2024 |
| | | | | US | 2024-0283256 | A1 | 22 August 2024 |
| US | 2017-0070061 | A1 | 09 March 2017 | CN | 107852011 | A | 27 March 2018 |
| | | | | CN | 114142563 | A | 04 March 2022 |
| | | | | US | 10044213 | B2 | 07 August 2018 |
| | | | | US | 10566819 | B2 | 18 February 2020 |
| | | | | US | 10892631 | B2 | 12 January 2021 |
| | | | | US | 2019-0006871 | A1 | 03 January 2019 |
| | | | | US | 2020-0144833 | A1 | 07 May 2020 |
| | | | | WO | 2017-044796 | A1 | 16 March 2017 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240069604